(19) Europäisches Patentamt
European Patent Office
Office européen des brevets

(11) **EP 2 609 573 B1**

(12) **FASCICULE DE BREVET EUROPEEN**

(45) Date de publication et mention
de la délivrance du brevet:
**23.07.2014 Bulletin 2014/30**

(21) Numéro de dépôt: **11761665.6**

(22) Date de dépôt: **24.08.2011**

(51) Int Cl.:
***G06T 7/20*** (2006.01)

(86) Numéro de dépôt international:
**PCT/FR2011/051961**

(87) Numéro de publication internationale:
**WO 2012/025697 (01.03.2012 Gazette 2012/09)**

(54) **PROCÈDE ET DISPOSITIF DE DÉTERMINATION DYNAMIQUE DE LA POSITION ET ORIENTATION DES ÉLÉMENTS OSSEUX DU RACHIS**

VERFAHREN UND VORRICHTUNG ZUR DYNAMISCHEN BESTIMMUNG DER POSITION UND AUSRICHTUNG DER WIRBELSÄULENKNOCHENELEMENTE

METHOD AND DEVICE FOR DYNAMICALLY DETERMINING THE POSITION AND ORIENTATION OF THE BONE ELEMENTS OF THE SPINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.08.2010 FR 1056765**

(43) Date de publication de la demande:
**03.07.2013 Bulletin 2013/27**

(73) Titulaires:
• **AXS Ingénierie**
**76068 Le Havre (FR)**
• **Université Lyon 1 Claude Bernard**
**69100 Villeurbanne (FR)**
• **Institut Français des Sciences et Technologies des**
**Transports, de l'Aménagement et des Réseaux**
**77420 Champs sur Marne (FR)**

(72) Inventeurs:
• **KOELL, Perrine**
**F-8590 Saint Hippolyte (FR)**
• **DUMAS, Raphaël**
**F-69100 Villeurbanne (FR)**
• **ELBAROUDI, Fouad**
**F-76310 Sainte Adresse (FR)**
• **CHEZE, Laurence**
**F-69006 Lyon (FR)**

(74) Mandataire: **Coralis Harle**
**14-16 Rue Ballu**
**75009 Paris (FR)**

(56) Documents cités:
**FR-A1- 2 904 455**

• **CERVERI P ET AL: "Non-invasive approach towards the in vivo estimation of 3D inter-vertebral movements: methods and preliminary results", MEDICAL ENGINEERING & PHYSICS, BUTTERWORTH-HEINEMANN, GB, vol. 26, no. 10, 1 décembre 2004 (2004-12-01), pages 841-853, XP004656240, ISSN: 1350-4533, DOI: DOI: 10.1016/J.MEDENGPHY.2004.08.005**
• **PETIT Y ET AL: "Patient-specific mechanical properties of a flexible multi-body model of the scoliotic spine", MEDICAL & BIOLOGICAL ENGINEERING & COMPUTING, SPRINGER, BERLIN, DE, vol. 42, no. 1, 1 janvier 2004 (2004-01-01), pages 55-60, XP019834624, ISSN: 1741-0444 cité dans la demande**
• **LEGAYE J ET AL: "Correction for patient sway in radiographic biplanar imaging for three-dimensional reconstruction of the spine: in vitro study of a new method.", septembre 2009 (2009-09), ACTA RADIOLOGICA (STOCKHOLM, SWEDEN : 1987) SEP 2009 LNKD- PUBMED: 19551533, VOL. 50, NR. 7, PAGE(S) 781 - 790, XP002626639, ISSN: 1600-0455 section "Material and methods" figure 3**

## Description

La présente invention concerne un procédé de détermination dynamique de la position et orientation des éléments osseux du rachis ainsi qu'un dispositif adapté à cette fin. Elle a des applications dans le domaine de l'imagerie notamment médicale. Les utilisations possibles de la présente invention sont le suivi non invasif et le diagnostic de pathologies rachidiennes ainsi que des études de mobilité du rachis, plus particulièrement des études pseudo-cinématiques, c'est-à-dire entre des positions statiques.

Il existe aujourd'hui un intérêt croissant pour la reconstruction en trois dimensions (3D) personnalisée de la colonne vertébrale, pour l'analyse de la posture et des mobilités du rachis. Plusieurs méthodes ont été développées pour déduire la configuration de la colonne vertébrale à partir de données externes (surface du dos ou marqueurs cutanés).

Ainsi, on connaît par le document WO 2008/012479 A1 un procédé de reconstruction en trois dimensions du rachis d'un individu et de ses relations avec la surface du dos à partir de radiographies classiques en deux dimensions et imagerie de surface du dos en trois dimensions. A cette fin, un moyen de calcul itératif utilisant des données numérisées desdites radiographies et de l'imagerie de surface est mis en oeuvre. Des repères visibles en radiographie et sur la surface du dos sont employés. Ce procédé est statique en ce sens que si l'on souhaite obtenir une nouvelle reconstruction du rachis dudit individu après que son rachis ait bougé ou se soit déformé, il est nécessaire de recommencer tout le procédé avec de nouvelles radiographies et de nouvelles prises d'images 3D de la surface du dos de l'individu. Il en résulte que l'individu doit de nouveau être irradié par des rayons X et que de nouveaux traitements des radiographies (souvent fastidieux comme par exemple l'identification de points anatomiques) doivent être recommencés à partir de zéro. Les informations brutes ou calculées obtenues lors de la première reconstruction sont sans utilité pour la seconde reconstruction du rachis.

Or, il est utile de disposer d'informations sur le rachis d'un individu pour plusieurs positions ou au cours de l'évolution des déformations de ce rachis. Il est donc souhaitable de disposer d'un procédé dynamique de reconstruction en trois dimensions du rachis qui utilise au mieux les données disponibles, qu'elles soient brutes (résultant des prises de vues radiographiques en deux dimensions et du dos en trois dimensions ou d'autres procédés permettant une reconstruction 3D du rachis) ou le résultat de calculs (reconstitution 3D du rachis et relations rachis - surface du dos). Il est également souhaitable que l'individu ne soit pas soumis à un rayonnement X important et donc que le nombre de radiographies soit réduit au strict minimum.

Or, dans le domaine de l'analyse du mouvement du rachis, des modèles cinématiques ont été élaborés à partir d'une ou plusieurs configurations initiales par exemple en utilisant une ou des radiographies et des marqueurs cutanés en vue d'obtenir d'autres configurations (en continue ou non). Cependant, la cinématique du rachis est très complexe en raison du nombre élevé de vertèbres articulées et la résolution est sous contrainte s'il n'y a pas suffisamment de marqueurs cutanés. Ainsi, des lois de coordination complexes doivent souvent être mises en oeuvre pour utiliser ces modèles cinématiques car le nombre de marqueurs externes serait trop prohibitif pour suivre le rachis en entier. Pour ces raisons, seuls les modèles cervicaux et lombaires ont été développés jusqu'à présent, et uniquement dans le plan sagittal. De tels modèles ont par exemple été proposés dans les documents suivants :

- Zhang, Xiong, "Model-guided derivation of lumbar vertebral kinematics in vivo reveals the difference between external marker-defined and internal segmental rotations", Journal of biomechanics, vol. 36, pp 9-17, 2003;
- Sun, Lee, Lu, Luk, "Modelling and simulation of the intervertebral movements of the lumbar spine using an inverse kinematic algorithm", Med. Biol. Eng. Comput., vol. 42, pp. 740-746, 2004; et
- F. Marin, N. Hoang, P. Aufaure, M.-C. Ho Ba Tho, "In vivo intersegmental motion of the cervical spine using an inverse kinematics procedure", Clinical Biomechanics, vol. 25, pp. 389-396, 2010.

Dans le domaine du suivi, et du diagnostic non invasif et de la planification du traitement (chirurgical ou orthopédique), des modèles mathématiques, en éléments finis et multi-corps dynamiques ont été développés. Les modèles mathématiques sont basés sur des corrélations statistiques ou des relations géométriques entre la colonne vertébrale et la surface du dos comme explicité dans les documents suivants :

- B. Drerup, E. Hierholtzer, "Back shape measurement using video rasterstereography and three-dimensional reconstruction of spinal shape", Clinical Biomechanics, vol. 9, pp. 28-36, 1994;
- Huysmans, Haex, Van Audekercke, Vander Sloten, Van der Perre, "Three-dimensional mathematical reconstruction of the spinal shape, based on active contours", Journal of Biomechanics, vol.37, pp. 1793-1798, 2004; et
- D'amico M, D'amico G, Roncoletta, Tomassini, Ciarrocca, Vallasciani, "A 3-D biomechanical skeleton model and processing procedure for posture and movement analysis", Europa Medicophysica, vol. 43, pp. 1-6, 2007.

L'avantage de ces derniers modèles mathématiques est la facilité de leur mise en oeuvre, mais le rachis n'est pas personnalisé. Dans les modèles en éléments finis, une géométrie initiale et des lois de comportement des matériaux doivent être déterminée. Jusqu'à présent, ces modèles sont avant tout utilisés pour simuler des actes médicaux : opérations chirurgicales (Lafage, Dubousset, Lavaste, Skalli, "3D finite element simulation of cotrel-dubousset correction", Computer Aided Surgery, vol. 9, pp. 17-25, 2004) ou mise en place de corsets (D. Périé, C.-E. Aubin, M. Lacroix, Y: Lafon, H. Labelle, "Biomechanical modelling of orthotic treatment of the scoliotic spine including a detailed representation of the brace-torso interface", Med. Biol. Eng. Comput, vol. 42, pp. 339-344, 2004). En ce qui concerne les modèles multi-corps dynamiques, une configuration initiale, ainsi que la position des centres articulaires et la raideur de leurs liaisons doivent être déterminés. Ces modèles n'incluent pas de contraintes supplémentaires, comme par exemple des corrélations entre le rachis et la surface du dos. Jusqu'à présent, ces modèles sont utilisés pour simuler des opérations chirurgicales (Aubin, Petit, Stokes, Poulin, Gardner-Morse, Labelle, "Biomechanical modeling of posterior instrumentation of the scoliotic spine", Computer methods in biomechanics and biomedical engineering, vol. 21, pp. 77-88, 2003 ou Y. Petit, C-E. Aubin, H. Labelle, "Patient-specific mechanical properties of a flexible multi-body model of the scoliotic spine", Medical & Biological Engineering & Computing, vol. 42, pp. 55-60, 2004).

Pour remédier aux limites des techniques connues, il est proposé la mise en oeuvre d'un modèle dynamique prédictif de la configuration du rachis. Ce modèle dynamique personnalisé a pour but de prédire la position et l'orientation des vertèbres d'un rachis à un temps t+1, connaissant leurs positions et leurs orientations au temps t ainsi que la position de la surface du dos aux temps t et t+1. Grâce à ce modèle dynamique de rachis, il est possible de reconstruire en trois dimensions le rachis à un temps t+1, à partir d'une simple imagerie 3D de la surface du dos au dit temps t+1, et en utilisant des informations obtenues précédemment, dans un temps préalable t, avant déplacement/déformation du rachis de l'individu, notamment à partir de radiographies numériques bi-planaires, de préférence seulement deux radiographies, et d'imagerie externe 3D de la surface du dos au temps t préalable et qui sont traitées par un procédé permettant la reconstruction 3D du rachis et de la surface du dos à ce temps t préalable. Le procédé utilisé à ce temps t préalable pour la reconstruction 3D du rachis, est de préférence celui mis en oeuvre et décrit dans le document WO 2008/012479 A1, associé à un procédé de reconstruction 3D de la surface du dos et permettant l'établissement des relations entre le rachis et la surface du dos à ce temps t. Toutefois, tout autre procédé de reconstruction 3D du rachis et des relations rachis - surface du dos peut être mis en oeuvre à ce temps t préalable.

L'objectif du modèle dynamique de rachis de la présente invention, est de permettre de déterminer une configuration personnalisée du rachis en 3D, en connaissant la configuration du rachis et de la surface du dos à un temps préalable t ainsi que la configuration de la surface du dos à un temps final t+1.

L'invention concerne donc un procédé de détermination dynamique de la position et orientation des éléments osseux du rachis d'un individu par imagerie interne, notamment radiologique avec numérisation de radiographies 2D du rachis, et imagerie externe 3D de la surface du dos dudit individu et calculs dans un moyen de calcul, le rachis étant formé d'un empilement de vertèbres articulées entre elles, chacune des articulations étant assimilée à une rotule entre deux vertèbres adjacentes avec une raideur articulaire exprimée sous forme matricielle.

Selon l'invention, dans un premier temps correspondant à un temps déterminé t, par un procédé d'imagerie on calcule pour ledit temps déterminé t les position et orientation statiques de chacune des vertèbres du rachis ainsi que la géométrie de la surface du dos afin notamment de pouvoir déterminer les relations des vertèbres entre elles et par rapport à la surface du dos et au moins un point de référence de ladite surface du dos, et par modélisation, on détermine des équations d'un modèle mécanique dynamique du rachis formé par des articulations entre les vertèbres ainsi que celles liées à des forces et/ou contraintes internes au rachis et à des forces et/ou contraintes d'interaction entre le rachis et la surface du dos, le rachis étant modélisé sous forme d'un vecteur de paramètres donnant les position et orientation de chaque vertèbre, et dans un second temps correspondant à un temps déterminé t+1, le rachis s'étant déplacé et/ou déformé, en replaçant le/les points de référence sur la surface du dos dudit individu, on réalise et numérise des images 3D de la surface externe du dos dudit individu, et

on calcule pour ledit temps t+1 les position et orientation de chacune des vertèbres à partir, d'une part, des données d'images 3D de la surface externe du dos du temps t+1 et, d'autre part, des données de position et orientation statiques de chacune des vertèbres ainsi que de la géométrie de la surface du dos du temps t, par résolution du modèle dynamique du rachis représenté par ses équations avec application de forces et de contraintes ,

les forces et contraintes étant, d'une part, des forces et des contraintes internes au rachis, et étant alors des contraintes cinématiques liées aux liaisons entre les vertèbres et des raideurs articulaires,

les forces et contraintes étant, d'autre part, des forces et des contraintes d'interactions entre le rachis et la surface du dos, et étant alors des contraintes motrices liées aux déplacement du/des points de référence et des forces dues aux raideurs linéaires pour la distance vertèbre / surface du dos et aux raideurs angulaires pour l'orientation vertèbre / surface du dos.

Dans divers modes de mise en oeuvre de l'invention, les moyens suivants pouvant être utilisés seuls ou selon toutes les combinaisons techniquement possibles, sont employés :

- dans le premier temps correspondant au temps déterminé t, on réalise et numérise un ensemble de radiographies 2D du rachis et d'images 3D de la surface du dos de l'individu, des repères visuels externes visibles sur les images externes et en radiographie étant disposés sur la surface du dos de l'individu, au moins un des repères visuels étant un point de référence correspondant à la projection sur la surface du dos d'un point anatomique situé le long du rachis dudit individu et déterminable par un opérateur, on calcule pour ledit temps déterminé t les position et orientation statiques de chacune des vertèbres du rachis ainsi que la géométrie de la surface du dos afin notamment de pouvoir déterminer les relations des vertèbres entre elles et par rapport à la surface du dos dont au moins ledit au moins un point de référence,

- en alternative à la radiographie 2D, il est mis en oeuvre tout autre procédé d'imagerie radiologique dont 3D comme la tomodensitométrie (scanner X), voire même la résonance magnétique nucléaire (IRM) pour obtenir au moins les position et orientation statiques de chacune des vertèbres du rachis au temps t,
- le point de référence visible en imagerie externe de la surface du dos est aussi visible en radiologie,
- le point de référence visible en imagerie externe de la surface du dos n'est pas visible en radiologie,
- la modélisation du rachis est un vecteur de douze paramètres par vertèbre, lesdits paramètres étant :

un vecteur $u_i$ d'un axe postéro-antérieur de repère local de la vertèbre et exprimé dans un repère global,
un vecteur $v_i$ d'un axe transversal de repère local de la vertèbre et exprimé dans le repère global,
un vecteur $r_{Ui}$ des coordonnées du centre de l'articulation entre la vertèbre i et la vertèbre supérieure (i+1), exprimé dans le repère global, et
un vecteur $r_{Di}$ des coordonnées du centre de l'articulation entre la vertèbre i et la vertèbre inférieure (i-1), exprimé dans le repère global,
lesdits paramètres étant contraints entre eux, chaque vertèbre étant considérée comme un corps rigide, lesdites contraintes de corps rigide s'exprimant par les relations :

$$u_i^2 - 1 = 0$$

$$v_i^2 - 1 = 0$$

$$(r_{Ui} - r_{Di})^2 - L_i^2 = 0$$

$$u_i \, v_i = 0$$

$$u_i(r_{Ui} - r_{Di}) - L_i \cos\beta_i = 0$$

$$v_i(r_{Ui} - r_{Di}) - L_i \cos\alpha_i = 0,$$

les valeurs $L_i$, $\alpha_i$ et $\beta_i$ étant fixes et étant calculées au temps initial t,

- chacun des vecteurs $u_i$, $v_i$, $r_{Ui}$ et $r_{Di}$ est un vecteur 3x1,
- les douze paramètres, soumis aux contraintes de corps rigide ci-dessus, donnent six degrés de liberté à chaque vertèbre du modèle de rachis,
- le vecteur $u_i$ est celui d'un axe de repère local orienté vers l'avant de la vertèbre,
- le vecteur $u_i$ est celui d'un axe de repère local orienté vers l'arrière de la vertèbre,
- le vecteur $v_i$ du repère local de la vertèbre est orienté vers la gauche de la vertèbre,
- le vecteur $v_i$ du repère local de la vertèbre est orienté vers la droite de la vertèbre,
- les contraintes cinématiques expriment le fait que le centre de rotation inférieur d'une vertèbre est confondu avec le centre de rotation supérieur de la vertèbre adjacente

inférieure, ladite contrainte s'exprimant par la relation suivante des paramètres du vecteur modélisant le rachis : $r_{Di} - r_{Ui-1} = 0$ dans laquelle $r_{Ui}$ est le vecteur des coordonnées du centre de l'articulation entre la vertèbre i et la vertèbre supérieure (i+1), exprimé dans le repère global et $r_{Di}$ est le vecteur des coordonnées du centre de l'articulation entre la vertèbre i et la vertèbre inférieure (i-1), exprimé dans le repère global,

- les contraintes liées aux raideurs articulaires intervertébrales sont exprimées par l'équation :

$$\begin{vmatrix} M_u \\ M_v \\ M_w \end{vmatrix} = - \begin{bmatrix} k_{uu} & 0 & k_{uw} \\ 0 & k_{vv} & 0 \\ k_{wu} & 0 & k_{ww} \end{bmatrix} \begin{vmatrix} \theta_u \\ \theta_v \\ \theta_w \end{vmatrix}$$

dans laquelle M représente des moments articulaires dans le repère local, et ensuite exprimé dans le repère global, k des raideurs angulaires et $\theta$ correspond aux variations angulaires intervertébrales dans le mouvement relatif entre les temps t et t+1,
- les contraintes motrices sont définies par les déplacements de plusieurs points de référence le long du rachis,
- les contraintes motrices sont définies par les déplacements d'un seul point de référence le long du rachis,
- chaque point de référence correspond à la projection de l'épineuse d'une vertèbre déterminée sur la surface du dos de l'individu,
- les contraintes motrices sont définies par les déplacements d'un seul point de référence le long du rachis, ledit point de référence correspondant à la projection de l'épineuse de la vertèbre C7 sur la surface du dos de l'individu,
- les raideurs d'interactions entre le rachis et la surface du dos sont modélisées à l'aide de ressorts de rappel sur lesquels des forces s'appliquent, la force liée à la distance vertèbre / surface du dos correspondant pour chaque vertèbre à une équation de rappel $F_p = -k_{v\text{-peau}} * (rE_i - proj\_Ep_i)$ où $F_p$ est une force de rappel dans le repère global, $k_{v\text{-peau}}$ est une raideur linéaire, $rE_i$ est la projection du centre du corps vertébral de la vertèbre sur la ligne des épineuses en position initiale du temps t, et $proj\_Ep_i$ la projection du centre du corps vertébral sur la ligne des épineuses en position finale du temps t+1, et la force liée à l'orientation vertèbre / surface du dos correspondant pour chaque vertèbre à une équation de rappel $m_{torsion} = -k_{torsion} *(\theta_{vertèbre} - \theta_{gibbosité})$ où $m_{torsion}$ est un moment de rappel suivant l'axe Z du repère local de la vertèbre, $k_{torsion}$ est une raideur angulaire, $\theta_{vertèbre}$ un angle de rotation de vertèbre, et $\theta_{gibbosité}$ un angle de gibbosité, la résolution desdites équations de rappel du rachis avec la surface du dos entre les deux temps permettant de calculer des efforts appliqués aux vertèbres du rachis lors de sa déformation et/ou son déplacement entre les deux temps,
- Mtorsion est l'expression de $m_{torsion}$ dans le repère global,
- l'équation du modèle mécanique dynamique du rachis est :

$$\begin{cases} \phi = 0 \\ [M][\ddot{q}] + [K]^T[\lambda] = [Q] \end{cases}$$

où :

$\phi$ est le vecteur des contraintes de corps rigide, cinématiques et motrices,
M est la matrice des masses des vertèbres,
q¨ est le vecteur des accélérations des paramètres q,
K est la jacobienne du vecteur des contraintes,
$\lambda$ est le vecteur des multiplicateurs de Lagrange, et
Q est le vecteur des efforts généralisés correspondant aux efforts dus aux raideurs articulaires et aux raideurs d'interactions entre le rachis et la surface du dos, et les conditions d'équilibre statique suivantes s'y appliquent :

$$[K]^T[\lambda] - [Q] = [0]$$
$$\text{Et } [\phi] = [0]$$

- la matrice M des masses est calculée en fonction de la géométrie et de la masse de chacune des vertèbres,- la géométrie de chaque vertèbre est calculée/estimée à partir des résultats de la reconstruction 3D du rachis au temps t,
- la masse est déterminée en fonction du volume calculé de la vertèbre et d'une valeur déterminée de densité osseuse,
- la résolution de l'équation du modèle mécanique dynamique du rachis est obtenue soit par une méthode d'optimisation sous contrainte où les contraintes à respecter sont les contraintes de corps rigide, les contraintes cinématiques, et les contraintes motrices et la fonction à minimiser est l'énergie potentielle due aux raideurs articulaires et aux raideurs d'interactions entre le rachis et la surface du dos, soit par une méthode de résolution itérative d'intégration des équations de la dynamique, l'équation du modèle mécanique dynamique du rachis étant résolue par résolution du système :

$$\left|\begin{matrix}\ddot{q}\\\lambda\end{matrix}\right| = \left[\begin{matrix}[M] & [K]^T\\ [K] & [0]\end{matrix}\right]^{-1} \left|\begin{matrix}[Q]\\ -[\dot{K}]\dot{q}\end{matrix}\right|$$

où $\ddot{q}$ est l'accélération, $\dot{q}$ la vitesse des paramètres q au cours du temps, des intégrations des accélérations et des vitesses au cours du temps permettant de déterminer les vitesses $\dot{q}$ et les paramètres q jusqu'au second temps t+1,

- on calcule en outre pour ledit temps t+1 la géométrie de la surface du dos du temps t+1, et pour calculer les position et orientation de chacune des vertèbres à un temps ultérieur à t+1 à partir d'images 3D de la surface externe du dos dudit individu réalisées au dit temps ultérieur et tout en replaçant le/les points de référence sur la surface du dos dudit individu, on utilise les résultats des calculs des position et orientation de chacune des vertèbres et la géométrie de la surface du dos au temps précédent obtenus à partir d'images 3D de la surface externe du dos dudit individu réalisées au dit temps précédent,
- la modélisation est réalisée une fois pour toute,
- la modélisation est réalisée à la demande,
- la modélisation est adaptée à chaque individu,
- le moyen de calcul comporte plusieurs modélisations pour le modèle mécanique dynamique du rachis et/ou pour les modèles de contraintes internes et/ou pour les modèles de contrainte d'interactions du rachis avec la surface du dos et/ou pour le vecteur de paramètres,
- le moyen de calcul effectue plusieurs déterminations avec les différentes modélisations,
- les images 3D externes sont réalisées par mise en oeuvre d'une technique d'imagerie qui peut être optique par exemple,

L'invention concerne également un dispositif spécialement adapté et configuré pour la mise en oeuvre du procédé de l'invention.

La présente invention, sans qu'elle en soit pour autant limitée, va maintenant être illustrée avec la description qui suit en relation avec :

la Figure 1 qui schématise le paramétrage des vertèbres en coordonnées dites naturelles,
la Figure 2 qui schématise les contraintes de corps rigide,
la Figure 3 qui schématise les contraintes cinématiques,
La Figure 4 qui schématise la prise en compte de contraintes motrices dans le modèle dynamique, sous forme du déplacement d'un point déterminé du rachis entre les positions initiale $r_{Ei}$ au temps t et finale $r_{Ei}^*$ au temps t+1, positions connues du fait de leur repérage (point(s) de référence(s)) et des acquisitions,
la Figure 5 qui schématise une méthode de résolution des équations de la dynamique du modèle dynamique prenant en compte des contraintes,
la Figure 6 qui schématise les forces d'interactions entre le rachis et la surface du dos de type raideurs linéaires pour la distance vertèbre / surface du dos,
la Figure 7 qui schématise les forces d'interactions entre le rachis et la surface du dos de type raideurs angulaires pour l'orientation vertèbre / surface du dos, et
la Figure 8 qui schématise l'ensemble de la méthode de prédiction dynamique de la configuration du rachis.

L'invention concerne donc un procédé de détermination dynamique de la position et de l'orientation des éléments osseux du rachis d'un individu par imagerie interne, notamment numérisation de radiographies 2D dudit individu, et d'imagerie externe 3D de la surface du dos dudit individu et calculs dans un moyen de calcul, notamment programme informatique dans un (micro-)ordinateur. Dans son principe, on détermine les équations d'un modèle mécanique dynamique du rachis et de contraintes internes au rachis et d'interactions du rachis avec la surface du dos, et, dans un premier temps t, par, notamment, radiographies 2D du rachis, et d'images 3D de la surface du dos, on calcule les relations des vertèbres entre elles et par rapport à la surface du dos, dans un second temps t+1, on réalise des images 3D de la surface externe du dos dudit individu, et on calcule pour ledit temps t+1 les position et orientation de chacune des vertèbres à partir, d'une part, des données acquises d'images 3D de la surface externe du dos du temps t+1 et, d'autre part, des données calculées de position et orientation statiques de chacune des vertèbres ainsi que de la géométrie de la surface du dos du temps t, par résolution du modèle dynamique du rachis représenté par ses équations avec application de forces et de contraintes internes au rachis, étant alors des contraintes cinématiques liées aux liaisons entre les vertèbres et des raideurs articulaires, et avec application de forces et de contraintes d'interactions entre le rachis et la surface du dos, étant alors des contraintes motrices liées aux déplacement du/des points de référence et des raideurs linéaires pour la distance vertèbre / surface du dos et des raideurs angulaires pour l'orientation vertèbre / surface du dos,

Le modèle dynamique utilisé pour la mise en oeuvre de l'invention est établi sur la base de la géométrie du rachis (squelette osseux) et du dos (surface du dos) obtenus lors d'une acquisition initiale (position et orientation des vertèbres, surface du dos) à un premier temps préalable dit t.

Pour obtenir les données initiales à traiter, on peut par exemple utiliser un système de reconstruction 3D de rachis et surface du dos à l'aide de radiographies bi-planaires calibrées et d'acquisitions optiques par franges de Moiré simultanées comme explicité dans la demande WO 2008/012479 A1.

A cette fin, dans ce premier temps, préalable, t on réalise deux radiographies bi-planaires du rachis, une de face et une de profil ainsi qu'une imagerie de surface avec acquisition en trois dimensions de la surface du dos par une technique des franges de Moiré. Des repères visibles en radiologie et en imagerie de surface sont disposés sur le sujet. En outre on place au moins un point de référence visible en imagerie de surface et correspond à la projection d'un point de référence du rachis sur la surface du dos. Un équipement informatique traite les données ainsi obtenues pour reconstruction en trois dimensions du rachis et fusion avec la surface du dos notamment afin que les relations entre les éléments du rachis et la surface du dos puissent être établies. Plus généralement, au temps préalable t, tout procédé permettant une reconstitution 3D du rachis et des relations du rachis avec la surface du dos peut être mis en oeuvre, dont radiologique ou résonance magnétique pour l'imagerie interne 2D, voir 3D, et laser ou Moiré pour l'imagerie externe 3D par exemple.

Ensuite, dans un deuxième temps, pour obtenir les données finales à traiter, c'est-à-dire au temps t+1, après mouvement/déformation du rachis par rapport au premier temps, préalable, t, on peut par exemple utiliser une reconstruction de la surface du dos issue d'une acquisition optique par franges de Moiré. Ainsi, dans ce deuxième temps t+1 (ou les temps suivants), seule une (des) acquisition externe par imagerie de surface avec acquisition en trois dimensions de la surface du dos est mise en oeuvre, aucune radiographie n'est nécessaire. Plus généralement, toute technique d'imagerie permettant une reconstruction 3D de la surface du dos peut être mise en oeuvre à ce temps t+1 et pas seulement la technique de Moiré.

Le modèle dynamique qui est donné dans la suite, prend en compte plusieurs variables dont les position et orientation des vertèbres du rachis. Le modèle est ainsi paramétré de manière à pouvoir décrire chaque vertèbre par ses position et orientation. Pour cela, au minimum 3 paramètres sont utilisés pour décrire en position et orientation une vertèbre donnée si les articulations sont supposées être des rotules. Dans ce cas aucune contrainte cinématique n'est nécessaire. A noter que si le paramétrage utilise plus de 6 paramètres par vertèbre, il faut alors relier ces paramètres entre eux non seulement à l'aide de contraintes cinématiques mais également à l'aide de corps rigide. Dans tous les cas, le rachis est décrit par un vecteur q contenant l'ensemble des paramètres pour toutes les vertèbres.

A titre d'exemple de paramétrage, on va utiliser un paramétrage avec 12 paramètres par vertèbre et, donc, avec des contraintes cinématiques et de corps rigide associées.

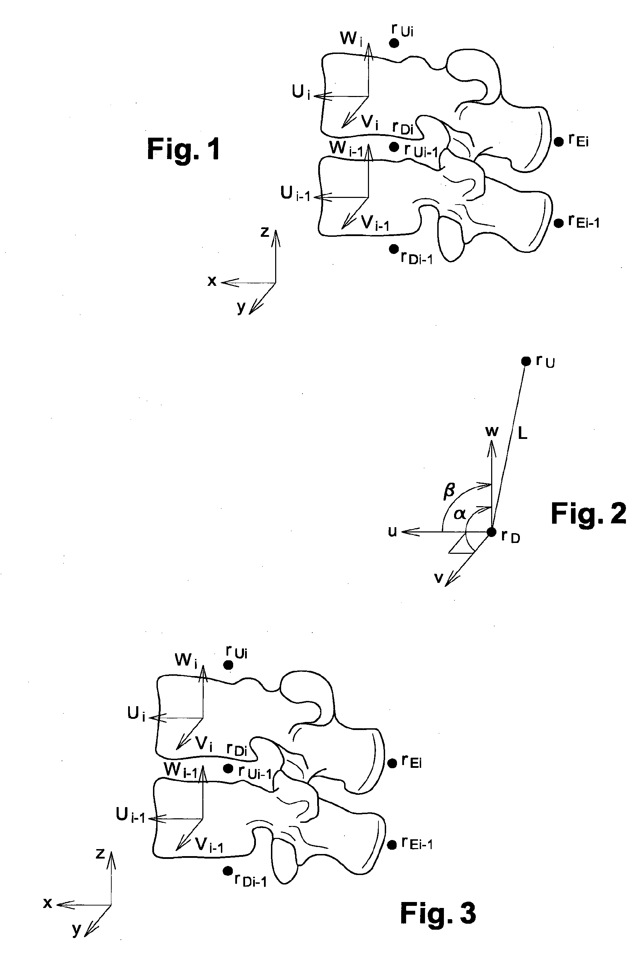

Cet exemple de paramétrage en relation avec la Figure 1 utilise des coordonnées naturelles et, dans ce cas, pour le rachis, chaque vertèbre est définie par deux points et deux vecteurs de la manière suivante :

- $u_i$ le vecteur du repère local de la vertèbre (cf. I. A. Stokes, "Three-dimensional terminology of spinal deformity. A report presented to the Scoliosis Research Society by the Scoliosis Research Society Working Group on 3-D terminology of spinal deformity," Spine, vol. 19, pp. 236-48, 1994), orienté vers l'avant de la vertèbre, exprimé dans le repère global (vecteur 3x1)
- $v_i$ le vecteur du repère local de la vertèbre orienté vers la gauche de la vertèbre, exprimé dans le repère global (vecteur 3x1)
- $r_{Ui}$ le vecteur des coordonnées du centre de l'articulation entre la vertèbre i et la vertèbre supérieure (i+1), exprimé dans le repère global (vecteur 3x1)
- $r_{Di}$ le vecteur des coordonnées du centre de l'articulation entre la vertèbre i et la vertèbre inférieure (i-1), exprimé dans le repère global (vecteur 3x1)

Ainsi, la description du rachis mise en oeuvre dans cet exemple comporte 12 paramètres par vertèbre pour 6 degrés de liberté et, dans ce cas, 6 contraintes de corps rigides doivent être introduites comme schématisé par la Figure 2 :

$$- u_i^2 - 1 = 0$$

$$- v_i^2 - 1 = 0$$

$$- (r_{Ui} - r_{Di})^2 - L_i^2 = 0$$

$$- u_i \, v_i = 0$$

$$- u_i(r_{Ui} - r_{Di}) - L_i \cos\beta_i = 0$$

$$- v_i(r_{Ui} - r_{Di}) - L_i \cos\alpha_i = 0$$

$L_i$, $\alpha_i$ et $\beta_i$ étant fixes et déterminés au temps préalable t.

Le rachis étant formé d'une suite d'articulations entre des vertèbres, on prend en compte dans la modélisation des contraintes cinématiques liées à ces articulations. A cette fin, on considère que des articulations, du type rotule, sont placées entre les vertèbres (cf. Y. Petit, C-E. Aubin, H. Labelle, "Patient-specific mechanical properties of a flexible multi-body model of the scoliotic spine", Medical & Biological Engineering & Computing, vol. 42, pp. 55-60, 2004). Par vertèbre, trois contraintes, dénommées contraintes cinématiques, sont introduites pour décrire ces articulations.

A titre d'exemple de contraintes cinématiques on va considérer le cas de vertèbres paramétrées avec des coordonnées naturelles comme schématisé Figure 3. Ces contraintes cinématiques imposent que le centre de rotation inférieur d'une vertèbre soit confondu avec le centre de rotation supérieur de la vertèbre adjacente inférieure : $r_{Di} - r_{Ui-1} = 0$.

Le modèle dynamique prend également en compte les efforts articulaires entre les vertèbres. Ces efforts articulaires sont liés à des raideurs articulaires. Dans l'exemple du rachis, ils sont introduits pour décrire les efforts dus aux rotations des vertèbres les unes par rapport aux autres. Ces raideurs articulaires peuvent être typiquement du type de celles présentées dans le document de Y. Petit, C-E. Aubin, H. Labelle, "Patient-specific mechanical properties of a flexible multi-body model of the scoliotic spine", Medical & Biological Engineering & Computing, vol. 42, pp. 55-60, 2004. Ces raideurs articulaires s'expriment par:

$$\begin{vmatrix} M_u \\ M_v \\ M_w \end{vmatrix} = - \begin{bmatrix} k_{uu} & 0 & k_{uw} \\ 0 & k_{vv} & 0 \\ k_{wu} & 0 & k_{ww} \end{bmatrix} \begin{vmatrix} \theta_u \\ \theta_v \\ \theta_w \end{vmatrix}$$

où M représente des moments articulaires, k des raideurs articulaires et $\theta$ correspond aux variations angulaires intervertébrales dans le mouvement relatif entre les temps t et t+1.

On vient de voir les forces et les contraintes internes au rachis qui sont considérées pour la résolution du modèle dynamique. On considère également des forces et des contraintes d'interactions entre le rachis et la surface du dos pour la résolution du modèle dynamique.

Afin de faciliter la résolution du modèle dynamique, on peut aussi mesurer le déplacement d'un ou de plusieurs points déterminés du rachis entre leurs positions initiale (au temps préalable t) et finale (au temps t+1). En pratique, le nombre de points déterminés dont on mesure les déplacements est réduit, quelques points déterminés, et, de préférence, réduit à un seul point déterminé. Typiquement, ce point déterminé est en relation avec la projection de l'épineuse de la vertèbre C7 sur la surface du dos, projection connue et marquée sur la surface du dos aux temps t et t+1 et correspondant au point de référence. Ce déplacement connu est une contrainte, appelée contrainte motrice, et on va l'appliquer au modèle pour que la résolution de ce dernier aboutisse à un tel déplacement.

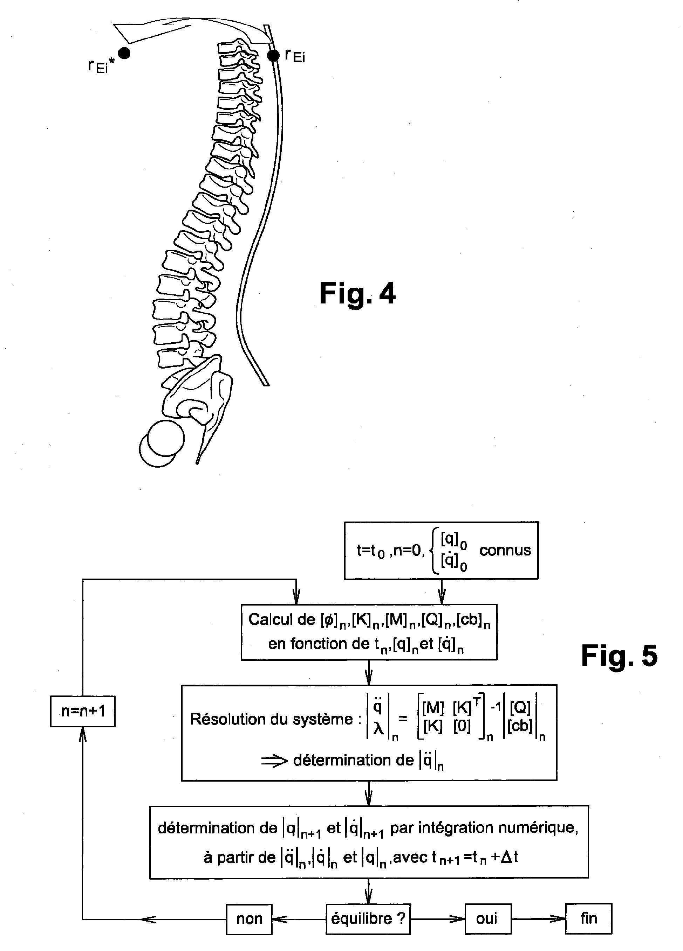

Ainsi, Figure 4, des contraintes motrices imposent le déplacement d'un point connu (projection de l'épineuse de C7 sur la surface du dos) entre les positions finale $r_{Ei}^*$ connues du fait de leur repérage et des acquisitions et sa position $r_{Ei}$ calculée par le modèle.

Les forces d'interactions entre le rachis et la surface du dos sont d'une part des raideurs linéaires pour la distance vertèbre / surface du dos et, d'autre part, des raideurs angulaires pour l'orientation vertèbre / surface du dos.

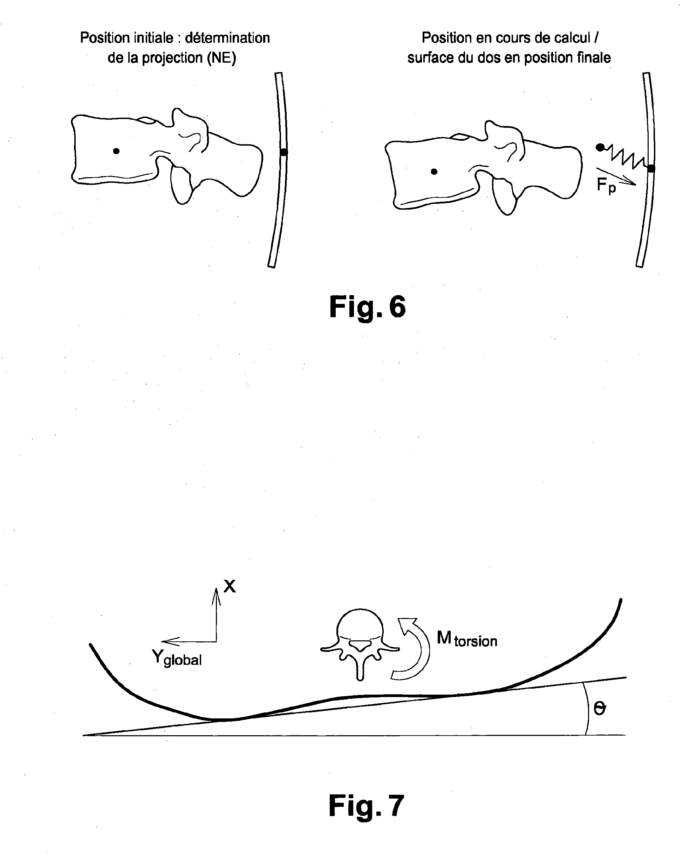

Pour ce qui concerne les raideurs linéaires pour la distance vertèbre / surface du dos, elles sont mises en oeuvre de la manière suivante. En position initiale (temps t), la projection de la vertèbre sur la ligne des épineuses (point de la ligne des épineuses le plus proche du centre vertébral) est calculée pour chaque vertèbre et la position de chaque projection est déterminée dans le repère de la vertèbre (coordonnées NE Figure 6). Ensuite, dans le calcul, ces coordonnées NE permettent de calculer les coordonnées rE (projection de la vertèbre à l'instant t) dans le repère global. Ces coordonnées sont comparées à celles de la projection de la vertèbre sur la ligne des épineuses en position finale (connue). Une force $F_p$ est appliquée sur la vertèbre, simulant un ressort tendant à ramener la projection sur le point de la ligne des épineuses objectif. Cette force est exprimée par la relation suivante :

$$F_p = -k_{v\text{-peau}} * (rE_i - proj\_Ep_i)$$

où $k_{v\text{-peau}}$ est une raideur et $proj\_Ep_i$ la projection de la vertèbre sur la ligne des épineuses en position finale.

Cette mise en oeuvre est schématisée sur la Figure 6 sur laquelle, à gauche, la vertèbre et la surface du dos sont dans leurs positions initiales (temps t) et on détermine la projection et, à droite, au cours d'une étape de calcul on tend à ramener la vertèbre à sa position finale, la surface du dos étant à sa position finale (t+1) toujours en en considérant la projection.

Pour ce qui concerne les raideurs angulaires pour l'orientation vertèbre / surface du dos, elles sont mises en oeuvre de la manière suivante. Pour chaque vertèbre, on définit une coupe de la surface du dos par l'intersection entre cette surface et le plan (centre vertèbre, $x_{local}$, $y_{global}$). On définit un angle de gibbosité entre la tangente à la surface du dos et le vecteur y du repère global. On applique alors un moment autour de l'axe z de la vertèbre pour faire coïncider l'orientation de la vertèbre avec l'angle de gibbosité.

$$m_{torsion} = -k_{torsion} * (\theta_{vertèbre} - \theta_{gibbosité}).$$

$m_{torsion}$ est ensuite exprimé dans le repère global et est alors désigné $M_{torsion}$.

Cette mise en oeuvre est schématisée sur la Figure 7

Les efforts calculés pour ces deux interactions entre le rachis et la surface du dos à l'aide des ressorts sont prises en compte dans le modèle dynamique.

Le modèle dynamique appliqué dans la présente invention est exprimé sous forme d'équations de la dynamique qui doivent être résolues par l'application des forces et des contraintes vues précédemment et de données qui sont les résultats obtenus dans le premier temps, préalable, t, de reconstruction 3D du rachis et de la surface du dos. Ces équations à résoudre sont :

$$\begin{cases} \phi = 0 \\ [M][\ddot{q}] + [K]^T[\lambda] = [Q] \end{cases} \qquad \textit{(Equation 1)}$$

où :

- $\phi$ est le vecteur des contraintes (contraintes de corps rigide, cinématiques, motrice par exemple sur C7)
- M est la matrice des masses (calculée en fonction de la géométrie et la masse des vertèbres)
- q" est le vecteur des accélérations des paramètres q
- K est la jacobienne du vecteur des contraintes
- $\lambda$ est le vecteur des multiplicateurs de Lagrange (inconnus)
- Q est le vecteur des efforts généralisés qui comporte les efforts issus des raideurs articulaires et des raideurs d'interactions entre le rachis et la surface du dos..

En outre, on considère qu'à l'équilibre statique, l'énergie potentielle du système est minimale. Il en résulte qu'à l'équilibre statique, les paramètres doivent respecter les équations suivantes :

$$[K]^T[\lambda] - [Q] = [0]$$
$$\text{Et } [\phi] = [0] \qquad \textit{(Equation 2)}$$

et l'énergie potentielle du système est alors minimale.

Toute méthode de résolution des équations de la dynamique peut être utilisée, comme par exemple :

(1) optimisation sous contrainte où les contraintes à respecter sont les contraintes de corps rigide, cinématiques, motrice (par exemple sur C7) et la fonction à minimiser est l'énergie potentielle due aux raideurs articulaires et aux raideurs d'interactions entre le rachis et la surface du dos.

(2) résolution par intégration des équations de la dynamique de manière itérative. Ainsi, la résolution du système :

$$\left|\begin{matrix} \ddot{q} \\ \lambda \end{matrix}\right| = \left[\begin{matrix} [M] & [K]^T \\ [K] & [0] \end{matrix}\right]^{-1} \left|\begin{matrix} [Q] \\ -[\dot{K}]\dot{q} \end{matrix}\right| \qquad \text{(Equation 3)}$$

permet de déterminer les accélérations $\ddot{q}$ au temps t lorsque les paramètres q et les vitesses $\dot{q}$ sont connus au temps t.

Par intégration des accélérations et des vitesses, on peut alors déterminer les vitesses $\dot{q}$ et les paramètres q au temps t+At. On répète alors les itérations jusqu'à la position d'équilibre au temps t+1 pour résoudre le système. Cette méthode itérative est schématisée sur la Figure 5.

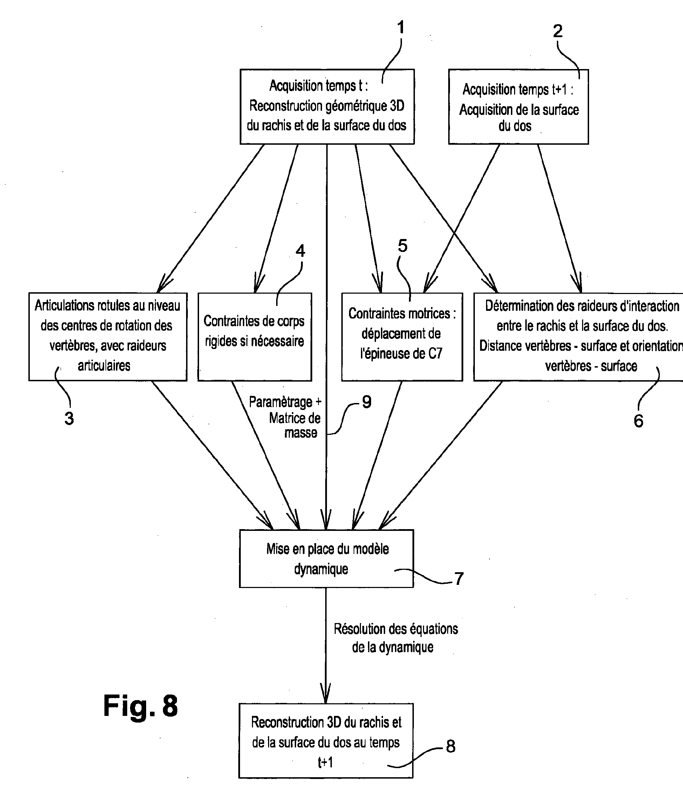

La figure 8 résume l'ensemble de la méthode de prédiction dynamique de la configuration du rachis à partir d'une détermination préalable au temps t et de l'acquisition de la surface du dos au temps t+1, à l'aide du modèle dynamique présenté, résolu grâce notamment à la prise en compte de relations internes - externes entre les éléments du rachis et la surface du dos.

Sur la Figure 8, dans le premier temps, préalable, on effectue en 1, simultanément, des acquisitions au temps t de radiographies biplanaires (face + profil) et d'imagerie de la surface du dos (en trois dimensions par une technique de Moiré) d'un sujet. Une fois ces acquisitions faites et les données numérisées pour traitement dans un équipement informatique, en 2, on effectue la reconstitution géométrique en trois dimensions du rachis et de la surface du dos. Avec ces reconstitutions, il est donc possible de connaître les relations entre les éléments du rachis et la surface du dos au temps t. Cette étapes 1 est effectuée en utilisant la méthode et les moyens de calibration présentés dans la demande WO 2008/012479 et avec un/des points de référence.

On rappelle que dans cette demande WO 2008/012479, le procédé d'imagerie informatisé présenté permet une reconstruction tridimensionnelle à partir d'images radiologiques bidimensionnelles. A cette fin, on dispose sur la surface du sujet un ensemble de repères visuels externes détectables par un capteur de surface permettant d'acquérir des images de surface tridimensionnelles de la surface du sujet, les repères visuels externes étant également radio-opaques. On associe à chaque image radiologique acquise une image de surface correspondante acquise sensiblement au même moment et on met en oeuvre un processus itératif comportant une phase de calcul d'incidence et une phase de calcul de déformation selon un processus itératif destinée à déterminer les positions relatives des images radiologiques et des images de surface ainsi qu'à effectuer un positionnement dans les trois dimensions des images radiologiques en supposant une absence de déformation du sujet et destinée à déterminer et corriger sur les images radiologiques les déformations du sujet pour les positions relatives déterminées dans la phase de calcul d'incidence, le critère d'arrêt de l'itération étant basé sur l'écart entre les coordonnées 3D des repères entre deux itérations successives. On rappelle que pour ce temps t, tout autre procédé permettant au moins de reconstituer en 3D le rachis peut être utilisé.

Dans un second temps, t+1, le même sujet, dont le rachis s'est déplacé, subit une nouvelle acquisition d'imagerie en trois dimensions de la surface de son dos à l'étape 2. On aura pris soin aussi bien au temps t qu'au temps t+1 de placer au moins un point de référence le long du rachis. En pratique un seul point de référence est mis en oeuvre et il correspond à la projection de l'épineuse de la vertèbre C7 (7ème cervicale) sur la surface du dos du sujet. Ce point de référence en relation avec l'épineuse de C7 va permettre de définir une contrainte motrice de déplacement de l'épineuse de C7 pour résoudre le modèle dynamique comme cela est schématisé à l'étape 5.

La prise en compte des autres contraintes et forces est schématisée :

-   à l'étape 3 pour ce qui concerne la mise en oeuvre d'articulations de type rotules au niveau des centres de rotation des vertèbres et ayant des raideurs articulaires,
-   à l'étape 4 pour ce qui concerne les contraintes de corps rigide, si cela est nécessaire parce que la modélisation utilise plus de six paramètres,
-   à l'étape 6 pour ce qui concerne les raideurs d'interaction entre le rachis et la surface du dos, ces contraintes étant les raideurs linéaires pour la distance vertèbre / surface du dos et les raideurs angulaires pour l'orientation vertèbre / surface du dos.

On a également représenté, Figure 8, le paramétrage permettant d'aboutir à la matrice de masse par la relation 9 et qui permet de mettre en place le modèle dynamique à l'étape 7 en prenant en compte les diverses contraintes et qui permettent la résolution des équations de la dynamique du modèle dynamique à l'étape 8 avec reconstruction en trois dimensions du rachis et de la surface du dos du temps t+1 et donc de leurs relations.

On comprend qu'il est possible de réitérer ces opérations pour suivre des mouvements au cours du temps, pour des temps t+2, t+3..., l'étape 1 étant toutefois remplacée par de précédentes mises en oeuvre de l'invention permettant tout comme l'étape 1 d'obtenir une reconstruction 3D du rachis et de la surface du dos, mais cette fois à partir de simples images de la surface du dos en trois dimensions du type de l'étape 2.

Si nécessaire, on peut au cours de ces réitérations ultérieures utilisant de simples images 3D de la surface du dos, intercaler un temps avec images radiologiques ou autre moyen d'imagerie interne pour mettre à jour le modèle et recaler les mesures et calculs et repartir sur des bases de résultats radiologiques ou de ces autres moyens. Dans tous les cas, le sujet recevra bien moins de rayonnements que si l'on répétait simplement à l'identique (avec imagerie radiologique à chaque fois) le principe de la Figure 8.

On comprend bien que l'invention peut être déclinée selon de nombreuses autres possibilités sans pour autant sortir du cadre défini par les revendications.

**Revendications**

1. Procédé de détermination dynamique de la position et orientation des éléments osseux du rachis d'un individu par imagerie interne, notamment radiologique par numérisation de radiographies 2D du rachis, et imagerie externe 3D de la surface du dos dudit individu et calculs dans un moyen de calcul, le rachis étant formé d'un empilement de vertèbres articulées entre elles, chacune des articulations étant assimilée à une rotule entre deux vertèbres adjacentes avec une raideur articulaire exprimée sous forme matricielle,

   **caractérisé en ce que**

   dans un premier temps correspondant à un temps déterminé t, par un procédé d'imagerie on calcule pour ledit temps déterminé t les position et orientation statiques de chacune des vertèbres du rachis ainsi que la géométrie de la surface du dos afin notamment de pouvoir déterminer les relations des vertèbres entre elles et par rapport à la surface du dos et au moins un point de référence de ladite surface du dos, et

   par modélisation, on détermine des équations d'un modèle mécanique dynamique du rachis formé par des articulations entre les vertèbres ainsi que celles liées à des forces et/ou contraintes internes au rachis et à des forces ou contraintes d'interaction entre le rachis et la surface du dos, le rachis étant modélisé sous forme d'un vecteur de paramètres donnant les position et orientation de chaque vertèbre, et

   dans un second temps correspondant à un temps déterminé t+1, le rachis s'étant déplacé et/ou déformé, en replaçant le/les points de référence sur la surface du dos dudit individu, on réalise et numérise des images 3D de la surface externe du dos dudit individu, et

   on calcule pour ledit temps t+1 les position et orientation de chacune des vertèbres à partir, d'une part, des données d'images 3D de la surface externe du dos du temps t+1 et, d'autre part, des données de position et orientation statiques de chacune des vertèbres ainsi que de la géométrie de la surface du dos du temps t, par résolution du modèle dynamique du rachis représenté par ses équations avec application de forces et de contraintes ,

   les forces et contraintes étant, d'une part, des forces et des contraintes internes au rachis, et étant alors des contraintes cinématiques liées aux liaisons entre les vertèbres, des raideurs articulaires et des contraintes de corps rigide,

   les forces et contraintes étant, d'autre part, des forces et des contraintes d'interactions entre le rachis et la surface du dos, et étant alors des contraintes motrices liées aux déplacement du/des points de référence et des forces dues aux raideurs linéaires pour la distance vertèbre / surface du dos et aux raideurs angulaires pour l'orientation vertèbre / surface du dos.

2. Procédé selon la revendication 1, **caractérisé en ce que** la modélisation du rachis est un vecteur de douze paramètres par vertèbre, lesdits paramètres étant :

   un vecteur $u_i$ d'un axe postéro-antérieur de repère local de la vertèbre et exprimé dans un repère global,
   un vecteur $v_i$ d'un axe transversal de repère local de la vertèbre et exprimé dans le repère global,
   un vecteur $r_{Ui}$ des coordonnées du centre de l'articulation entre la vertèbre i et la vertèbre supérieure (i+1), exprimé dans le repère global, et
   un vecteur $r_{Di}$ des coordonnées du centre de l'articulation entre la vertèbre i et la vertèbre inférieure (i-1), exprimé dans le repère global,
   lesdits paramètres étant contraints entre eux, chaque vertèbre étant considérée comme un corps rigide, lesdites contraintes de corps rigide s'exprimant par les relations :

$$u_i^2 - 1 = 0$$

$$v_i^2 - 1 = 0$$

$$(r_{Ui} - r_{Di})^2 - L_i^2 = 0$$

$$u_i \, v_i = 0$$

$$u_i(r_{Ui} - r_{Di}) - L_i\cos\beta_i = 0$$

$$v_i(r_{Ui} - r_{Di}) - L_i\cos\alpha_i = 0,$$

les valeurs $L_i$, $\alpha_i$ et $\beta_i$ étant fixes et étant calculées au temps initial t.

3. Procédé selon la revendication 1 ou 2, **caractérisé en ce que** les contraintes cinématiques expriment le fait que le centre de rotation inférieur d'une vertèbre est confondu avec le centre de rotation supérieur de la vertèbre adjacente inférieure, ladite contrainte s'exprimant par la relation suivante des paramètres du vecteur modélisant le rachis :

$$r_{Di} - r_{Ui-1} = 0$$

dans laquelle $r_{Ui}$ est le vecteur des coordonnées du centre de l'articulation entre la vertèbre i et la vertèbre supérieure (i+1), exprimé dans le repère global et
$r_{Di}$ est le vecteur des coordonnées du centre de l'articulation entre la vertèbre i et la vertèbre inférieure (i-1), exprimé dans le repère global.

4. Procédé selon l'une quelconque des revendications précédentes, **caractérisé en ce que** les contraintes liées aux raideurs articulaires intervertébrales sont exprimées par l'équation :

$$\begin{vmatrix} M_u \\ M_v \\ M_w \end{vmatrix} = - \begin{bmatrix} k_{uu} & 0 & k_{uw} \\ 0 & k_{vv} & 0 \\ k_{wu} & 0 & k_{ww} \end{bmatrix} \begin{vmatrix} \theta_u \\ \theta_v \\ \theta_w \end{vmatrix}$$

dans laquelle M représente des moments articulaires, k des raideurs articulaires et $\theta$ correspond aux variations angulaires intervertébrales dans le mouvement relatif entre les temps t et t+1.

5. Procédé selon la revendication 1, 2, 3 ou 4, **caractérisé en ce que** les contraintes motrices sont définies par les déplacements d'un seul point de référence le long du rachis, ledit point de référence correspondant à la projection de l'épineuse de la vertèbre C7 sur la surface du dos de l'individu.

6. Procédé selon l'une quelconque des revendications précédentes, **caractérisé en ce que** les contraintes d'interactions entre le rachis et la surface du dos sont modélisées à l'aide de ressorts de rappel sur lesquels des forces s'appliquent,
la force liée à la distance vertèbre / surface du dos correspondant pour chaque vertèbre à une équation de rappel

$$F_p = -k_{v\text{-}peau} \, {}^{*} \, (rE_i - proj\_Ep_i)$$

où $F_p$ est une force de rappel dans le repère global,

$k_{v\text{-peau}}$ est une raideur linéaire,

$rE_i$ est la projection du centre du corps vertébral de la vertèbre sur la ligne des épineuses en position initiale du temps t, et

$proj\_Ep_i$ la projection du centre du corps vertébral sur la ligne des épineuses en position finale du temps t+1,

et **en ce que** la force liée à l'orientation vertèbre / surface du dos correspondant pour chaque vertèbre à une équation de rappel

$$m_{torsion} = -k_{torsion} * (\theta_{vertèbre} - \theta_{gibbosité})$$

où $m_{torsion}$ est un moment de rappel suivant l'axe z du repère local de la vertebre,

$k_{torsion}$ est une raideur angulaire,

$\theta_{vertèbre}$ un angle de rotation axiale de vertèbre, et

$\theta_{gibbosité}$ un angle de gibbosité,

la résolution desdites équations de rappel du rachis avec la surface du dos entre les deux temps permettant de calculer des efforts appliqués aux vertèbres du rachis lors de sa déformation et/ou son déplacement entre les deux temps.

7. Procédé selon l'une quelconque des revendications précédentes, **caractérisé en ce que** l'équation du modèle mécanique dynamique du rachis est :

$$\begin{cases} \phi = 0 \\ [M][\ddot{q}] + [K]^T[\lambda] = [Q] \end{cases}$$

où :

$\phi$ est le vecteur des contraintes de corps rigide, cinématiques et motrices,

M est la matrice des masses des vertèbres,

q¨ est le vecteur des accélérations des paramètres q,

K est la jacobienne du vecteur des contraintes,

$\lambda$ est le vecteur des multiplicateurs de Lagrange, et

Q est le vecteur des efforts généralisés correspondant aux efforts dus aux raideurs articulaires et aux raideurs d'interactions entre le rachis et la surface du dos,

et **en ce que** les conditions d'équilibre statique suivantes s'y appliquent :

$$[K]^T[\lambda] - [Q] = [0]$$
$$\text{Et } [\phi] = [0].$$

8. Procédé selon la revendication 7, **caractérisé en ce que** la résolution de l'équation du modèle mécanique dynamique du rachis est obtenue soit par une méthode d'optimisation sous contrainte où les contraintes à respecter sont les contraintes de corps rigide, les contraintes cinématiques, et les contraintes motrices et la fonction à minimiser est l'énergie potentielle due aux raideurs articulaires et aux raideurs d'interactions entre le rachis et la surface du dos, soit par une méthode de résolution itérative d'intégration des équations de la dynamique, l'équation du modèle mécanique dynamique du rachis étant résolue par résolution du système :

$$\begin{vmatrix} \ddot{q} \\ \lambda \end{vmatrix} = \begin{bmatrix} [M] & [K]^T \\ [K] & [0] \end{bmatrix}^{-1} \begin{vmatrix} [Q] \\ -[\dot{K}]\dot{q} \end{vmatrix}$$

où $\ddot{q}$ est l'accélération, $\dot{q}$ la vitesse des paramètres q au cours du temps, des intégrations des accélérations et des vitesses au cours du temps permettant de déterminer les vitesses $\dot{q}$ et les paramètres q jusqu'au second temps t+1.

9. Procédé selon l'une quelconque des revendications précédentes, **caractérisé en ce que** l'on calcule en outre pour ledit temps t+1 la géométrie de la surface du dos du temps t+1, et **en ce que** pour calculer les position et orientation de chacune des vertèbres à un temps ultérieur t+1 à partir d'images 3D de la surface externe du dos dudit individu réalisées au dit temps ultérieur et tout en replaçant le/les points de référence sur la surface du dos dudit individu, on utilise les résultats des calculs des position et orientation de chacune des vertèbres et la géométrie de la surface du dos au temps précédent obtenus à partir d'images 3D de la surface externe du dos dudit individu réalisées au dit temps précédent.

10. Dispositif spécialement configuré pour la mise en oeuvre du procédé de l'une quelconque des revendications précédentes.

**Patentansprüche**

1. Verfahren zur dynamischen Bestimmung der Position und Ausrichtung der Wirbelsäulenknochenelemente eines Patienten durch interne, insbesondere radiologische Bildgebung durch Digitalisierung von 2D-Röntgenbildern der Wirbelsäule, und externe 3D-Bildgebung von der Oberfläche des Rückens des Patienten und Berechnungen in einem Berechnungsmittel, wobei die Wirbelsäule von einer Stapelung von untereinander gelenkig verbundenen Wirbeln gebildet ist, wobei jedes der Gelenke einem Kugelgelenk zwischen zwei aneinandergrenzenden Wirbeln mit einer Gelenksteifigkeit, die in Matrixform ausgedrückt ist, gleichgesetzt wird,
**dadurch gekennzeichnet, dass**
während einer ersten Zeit, die einer bestimmten Zeit t entspricht, durch ein Bildgebungsverfahren für die bestimmte Zeit t die statische Position und Ausrichtung jedes der Wirbel der Wirbelsäule sowie die Geometrie der Oberfläche des Rückens berechnet werden, um insbesondere die Relationen der Wirbel zueinander und in Bezug zur Oberfläche des Rückens und zu mindestens einem Referenzpunkt der Oberfläche des Rückens zu bestimmen, und
durch Modellierung Gleichungen eines dynamischen mechanischen Modells der Wirbelsäule bestimmt werden, die von Gelenken zwischen den Wirbeln sowie jenen, die mit inneren Kräften und/oder Spannungen der Wirbelsäule und Interaktionskräften oder -spannungen zwischen der Wirbelsäule und der Oberfläche des Rückens verbunden sind, gebildet ist, wobei die Wirbelsäule in Form eines Vektors von Parametern modelliert wird, der die Postition und Ausrichtung jedes Wirbels angibt, und
während einer zweiten Zeit, die einer bestimmten Zeit t+1 entspricht, wobei sich die Wirbelsäule verschoben und/oder verformt hat, wobei der/die Referenzpunkte auf der Oberfläche des Rückens des Patienten wieder angebracht werden, 3D-Bilder von der externen Oberfläche des Rückens des Patienten hergestellt und digitalisiert werden, und für die Zeit t+1 die Position und Ausrichtung jedes der Wirbel berechnet werden, einerseits auf Basis der 3D-Bilddaten der externen Oberfläche des Rückens der Zeit t+1 und andererseits auf Basis der statischen Positions- und Ausrichtungsdaten jedes der Wirbel sowie der Geometrie der Oberfläche des Rückens der Zeit t durch Auflösen des dynamischen Modells der Wirbelsäule, die durch ihre Gleichungen unter Anlegen von Kräften und Spannungen dargestellt ist,
wobei die Kräfte und Spannungen einerseits interne Kräfte und Spannungen der Wirbelsäule sind und somit kinematische Spannungen, die mit den Verbindungen zwischen den Wirbeln verbunden sind, Gelenksteifigkeiten und starre Körperspannungen sind, wobei die Kräfte und Spannungen andererseits Interaktionskräfte und -spannungen zwischen der Wirbelsäule und der Oberfläche des Rückens sind und somit Bewegungsspannungen, die mit den Verschiebungen des/der Referenzpunkte zusammenhängen, und Kräfte auf Grund der linearen Steifigkeiten für den Abstand Wirbel/Rückenoberfläche und der Winkelsteifigkeiten für die Ausrichtung Wirbel/Rückenoberfläche sind.

2. Verfahren nach Anspruch 1, **dadurch gekennzeichnet, dass** die Modellierung der Wirbelsäule ein Vektor von zwölf Parametern pro Wirbel ist, wobei die Parameter sind:

ein Vektor $u_i$ mit einer posteroanterioren Achse eines lokalen Bezugspunktes des Wirbels und ausgedrückt in einem globalen Bezugspunkt,
ein Vektor $v_i$ einer Querachse eines lokalen Bezugspunktes des Wirbels und ausgedrückt in dem globalen Bezugspunkt,
ein Vektor $r_{Ui}$ der Koordinaten des Zentrums des Gelenks zwischen dem Wirbel i und dem oberen Wirbel (i+1), ausgedrückt in dem globalen Bezugspunkt, und ein Vektor $r_{Di}$ der Korrdinaten des Zentrums des Gelenks zwischen dem Wirbel i und dem unteren Wirbel (i-1), ausgedrückt in dem globalen Bezugspunkt,
wobei die Parameter untereinander gespannt sind, wobei jeder Wirbel als ein starrer Körper betrachtet wird,
wobei die starren Körperspannungen durch folgende Relationen ausgedrückt sind:

$$u_i^2 - 1 = 0$$

$$v_i^2 - 1 = 0$$

$$(r_{Ui} - r_{Di})^2 - L_i^2 = 0$$

$$u_i v_i = 0$$

$$u_i(r_{Ui} - r_{Di}) - L_i \cos\beta_i = 0$$

$$v_i(r_{Ui} - r_{Di}) - L_i \cos\alpha_i = 0,$$

wobei die Werte $L_i$, $\acute{\alpha}_i$ und $\beta_i$ fix sind und zur Ausgangszeit t berechnet werden.

3. Verfahren nach Anspruch 1 oder 2, **dadurch gekennzeichnet, dass** die kinematischen Spannungen die Tatsache ausdrücken, dass das untere Rotationszentrum eines Wirbels mit dem oberen Rotationszentrum des angrenzenden unteren Wirbels zusammenfällt, wobei die Spannung durch die folgende Relation der Parameter des Vektors, der die Wirbelsäule modelliert, ausgedrückt wird:

$r_{Di} - r_{Ui} = 0$, wobei
$r_{Ui}$ der Vektor der Koordinaten des Zentrums des Gelenks zwischen dem Wirbel i und dem oberen Wirbel (i+1), ausgedrückt in dem globalen Bezugspunkt, ist, und
$r_{Di}$ der Vektor der Koordinaten des Zentrums des Gelenks zwischen dem Wirbel i und dem unteren Wirbel (i-1), ausgedrückt in dem globalen Bezugspunkt, ist.

4. Verfahren nach einem der vorhergehenden Ansprüche, **dadurch gekennzeichnet, dass** die Spannungen in Verbindung mit den Gelenksteifigkeiten zwischen den Wirbeln durch folgende Gleichung ausgedrückt sind:

$$\begin{vmatrix} M_u \\ M_v \\ M_w \end{vmatrix} = - \begin{bmatrix} k_{uu} & 0 & k_{uw} \\ 0 & k_{vv} & 0 \\ k_{wu} & 0 & k_{ww} \end{bmatrix} \begin{vmatrix} \theta_u \\ \theta_v \\ \theta_w \end{vmatrix}$$

wobei M Gelenkmomente, k Gelenksteifigkeiten darstellt und θ den Winkelvariationen zwischen den Wirbeln bei der relativen Bewegung zwischen den Zeiten t und t+1 entspricht.

5. Verfahren nach Anspruch 1, 2, 3 oder 4, **dadurch gekennzeichnet dass** die Bewegungsspannungen durch die Verschiebungen eines einzigen Referenzpunktes entlang der Wirbelsäule definiert sind, wobei der Referenzpunkt der Projektion des Wirbelfortsatzes des Wirbels C7 auf die Rückenoberfläche des Patienten entspricht.

6. Verfahren nach einem der vorhergehenden Ansprüche, **dadurch gekennzeichnet, dass** die Interaktionsspannungen zwischen der Wirbelsäule und der Rückenoberfläche mit Hilfe von Rückstellfedern modelliert werden, an die die Kräfte angelegt werden, wobei
die mit dem Abstand Wirbel/Rückenoberfläche verbundene Kraft für jeden Wirbel einer Rückstellgleichung entspricht:

$$F_p = -k_{v\text{-}peau} * (rE_i - proj\_Ep_i)$$

wobei $F_p$ eine Rückstellkraft in dem globalen Bezugspunkt ist,

$k_{v\text{-}peau}$ eine lineare Steifigkeit ist,

$rE_i$ die Projektion des Zentrums des Wirbelkörpers auf den Wirbel auf der Linie der Wirbelfortsätze in Ausgangsposition der Zeit t ist, und

$proj\_Ep_i$ die Projektion des Wirbelkörpers auf die Linie der Wirbelfortsätze in Endposition der Zeit t+1 ist,

und dass die mit der Ausrichtung Wirbel/Rückenoberfläche verbundene Kraft für jeden Wirbel einer Rückstellgleichung entspricht

$$m_{torsion} = -k_{torsion} * (\theta_{vertèbre} - \theta_{gibbosité})$$

wobei $m_{torsion}$ ein Rückstellmoment entlang der Achse z des lokalen Bezugspunktes des Wirbels ist,

$k_{torsion}$ eine Winkelsteifigkeit ist,

$\theta_{vertèbre}$ ein axialer Rotationswinkel des Wirbels ist, und

$\theta_{gibbosité}$ ein Gibbuswinkel ist,

wobei es die Auflösung der Rückstellgleichungen der Wirbelsäule mit der Rückenoberfläche zwischen den beiden Zeiten ermöglicht, Kräfte zu berechnen, die an die Wirbel der Wirbelsäule bei ihrer Verformung und/oder ihrer Verschiebung zwischen den beiden Zeiten angelegt werden.

**7.** Verfahren nach einem der vorhergehenden Ansprüche, **dadurch gekennzeichnet, dass** die Gleichung des dynamischen mechanischen Modells der Wirbelsäule folgende ist:

$$\begin{cases} \phi = 0 \\ [M][\ddot{q}] + [K]^T[\lambda] = [Q] \end{cases}$$

wobei:

$\varphi$ der Vektor der kinematischen und bewegungsabhängigen starren Körperspannungen ist,

M die Matrix der Massen der Wirbel ist,

$\dot{q}$ der Vektor der Beschleunigungen der Parameter q ist,

K die Jacobi-Matrix des Vektors der Spannungen ist,

$\lambda$ der Vektor der Lagrange-Multiplikatoren ist, und

Q der Vektor der generalisierten Kräfte ist,

entsprechend den Kräften auf Grund der Gelenksteifigkeiten und der Interaktionssteifigkeiten zwischen der Wirbelsäule und der Rückenoberfläche,

und dass die folgenden statischen Gleichgewichtsbedingungen hier anwendbar sind:

$$[K]^T[\lambda] - [Q] = [0]$$
$$Et\ [\phi] = [0].$$

**8.** Verfahren nach Anspruch 7, **dadurch gekennzeichnet, dass** die Auflösung der Gleichung des dynamischen mechanischen Modells der Wirbelsäule erzielt wird entweder durch eine Optimierungsmethode unter Spannung, wobei die zu berücksichtigenden Spannungen die starren Körperspannungen, die kinematischen Spannungen und die Bewegungsspannungen sind, und die zu minimierende Funktion die potentielle Energie auf Grund der Gelenksteifigkeiten und der Interaktionssteifigkeiten zwischen der Wirbelsäule und der Rückenoberfläche ist, oder durch eine iterative Integrationsauflösungsmethode der Gleichungen der Dynamik, wobei die Gleichung des dynamischen mechanischen Modells der Wirbelsäule durch Auflösung des folgenden Systems gelöst wird:

$$\begin{vmatrix} \ddot{q} \\ \lambda \end{vmatrix} = \begin{bmatrix} [M] & [K]^T \\ [K] & [0] \end{bmatrix}^{-1} \begin{vmatrix} [Q] \\ -[\dot{K}]\dot{q} \end{vmatrix}$$

wobei $\ddot{q}$ die Beschleunigung, $\dot{q}$ die Geschwindigkeit der Parameter q mit der Zeit ist, wobei es Integrationen der Beschleunigungen und der Geschwindigkeiten mit der Zeit ermöglichen, die Geschwindigkeiten $\dot{q}$ und die Parameter q bis zu der zweiten Zeit t+1 zu bestimmen.

9. Verfahren nach einem der vorhergehenden Ansprüche, **dadurch gekennzeichnet, dass** ferner für die Zeit t+1 die Geometrie der Rückenoberfläche der Zeit t+1 berechnet wird, und dass für die Berechnung der Position und Ausrichtung jedes der Wirbel zu einer späteren Zeit t+1 auf Basis von 3D-Bildern der externen Oberfläche des Rückens des Patienten, die zu der späteren Zeit hergestellt wurden und wobei der/die Referenzpunkte auf der Rückenoberfläche des Patienten wieder angebracht werden, die Ergebnisse der Berechnungen der Position und Ausrichtung jedes der Wirbel und die Geometrie der Rückenoberfläche zu der vorhergehenden Zeit verwendet werden, die auf Basis von 3D-Bildern der externen Oberfläche des Rückens des Patienten, die zu der vorhergehenden Zeit hergestellt wurden, erhalten wurden.

10. Vorrichtung, die speziell für den Einsatz des Verfahrens nach einem der vorhergehenden Ansprüche konfiguriert wurde.

**Claims**

1. A method for dynamically determining the position and orientation of the bone elements of the spine of an individual by internal imaging, in particular radiological imaging with digitization of 2D radiographs of the spine, and 3D external imaging of the surface of said individual's back and calculations by a calculation means, the spine being formed of a stack of vertebrae articulated to each other, each of the articulations being liken to a ball joint between two adjacent vertebrae with an articular stiffness expressed as a matrix,
**characterized in that**
at a first time corresponding to a determined time t, the static position and orientation of each of the spine vertebrae, as well as the back surface geometry, are calculated for said determined time t, by an imaging method, so as in particular to be capable of determining the relationships of the vertebrae between each other and with respect to the surface of the back and at least one reference point of said surface of the back, and equations of a dynamic mechanical model of the spine formed by articulations between the vertebrae, as well as those linked to forces and/or constraints internal to the spine and to forces or constraints of interaction between the spine and the surface of the back, are determined, by modeling, the spine being modeled as a vector of parameters giving the position and orientation of each vertebra, and
at a second time corresponding to a determined time t+1, the spine having been displaced and/or deformed, by replacing the reference point(s) on the surface of said individual's back, 3D images of the external surface of said individual's back are made and digitized, and
for said time t+1, the position and orientation of each of the vertebrae are calculated based, on the one hand, on 3D image data of the external surface of the back at the time t+1, and on the other hand, on static position and orientation data of each of the vertebrae, as well as the back surface geometry at the time t, by solving the dynamic model of the spine represented by the equations thereof with application of forces and constraints,
the forces and constraints being, on the one hand, forces and constraints internal to the spine, and being then kinematic constraints linked to the links between the vertebrae, articular stiffnesses and constraints of rigid body,
the forces and constraints being, on the other hand, forces and constraints of interaction between the spine and the surface of the back, and being then motor constraints linked to the displacement of the reference point(s) and forces dues to the linear stiffnesses for the vertebrae / back surface distance and the angular stiffnesses for the vertebrae / back surface orientation.

2. The method according to claim 1, **characterized in that** the spine model is a vector of twelve parameters per vertebra, said parameters being:

a vector $u_i$ of a postero-anterior axis of the vertebra local coordinate system, expressed in a global coordinate system,

a vector $v_i$ of a transverse axis of the vertebra local coordinate system, expressed in a global coordinate system,
a vector $r_{Ui}$ of the coordinates of the center of the articulation between the vertebra i and
the superior vertebra (i+1), expressed in the global coordinate system, and
a vector $r_{Di}$ of the coordinates of the center of the articulation between the vertebra i and the inferior vertebra
(i-1), expressed in the global coordinate system,
said parameters being constrained to each other, each vertebra being considered as a rigid body, said rigid-
body constraints being expressed by the following relations:

$$u_i^2 - 1 = 0$$

$$v_i^2 - 1 = 0$$

$$(r_{Ui} - r_{Di})^2 - L_i^2 = 0$$

$$u_i v_i = 0$$

$$u_i(r_{Ui} - r_{Di}) - L_i\cos\beta_i = 0$$

$$v_i(r_{Ui} - r_{Di}) - L_i\cos\alpha_i = 0,$$

the values $L_i$, $\alpha_i$ and $\beta_i$ being fixed and calculated at the initial time t.

3. The method according to claim 1 or 2, **characterized in that** the kinematic constraints express the fact that the inferior rotation center of a vertebra is merged with the superior rotation center of the adjacent inferior vertebra, said constraint being expressed by the following relation of the parameters of the vector modeling the spine:

$$r_{Di} - r_{Ui-1} = 0,$$

wherein
$r_{Ui}$ is the coordinate vector of the center of the articulation between the vertebra i and the superior vertebra (i+1), expressed in the global coordinate system, and
$r_{Di}$ is the coordinate vector of the center of the articulation between the vertebra i and the inferior vertebra (i-1), expressed in the global coordinate system.

4. The method according to any one of the preceding claims, **characterized in that** the constraints linked to the intervertebral articular stiffnesses are expressed by the equation:

$$\begin{vmatrix} M_u \\ M_v \\ M_w \end{vmatrix} = - \begin{bmatrix} k_{uu} & 0 & k_{uw} \\ 0 & k_{vv} & 0 \\ k_{wu} & 0 & k_{ww} \end{bmatrix} \begin{vmatrix} \theta_u \\ \theta_v \\ \theta_w \end{vmatrix}$$

wherein M represents articular moments, k represents articular stiffnesses and $\theta$ corresponds to the intervertebral angular variations in the relative movement between the times t and t+1.

5. The method according to claim 1, 2, 3 or 4, **characterized in that** the motor constraints are defined by the displacements of a single reference point along the spine, said reference point corresponding to the projection of the C7 vertebra spine on the surface of the individual's back.

6. The method according to any one of the preceding claims, **characterized in that** the constraints of interaction between the spine and surface of the back are modeled using return springs on which forces are applied, the force linked to the vertebra / back surface distance corresponding for each vertebra to a spring-back equation

$$F_p = -k_{v\text{-peau}} * (rE_i - proj\_Ep_i),$$

wherein
Fp is a spring-back force in the global coordinate system,
$k_{v\text{-peau}}$ is a linear stiffness,
$rE_i$ is the projection of the center of the vertebral body of the vertebra on the line of the vertebral spinous processes in the initial position at time t, and
$proj\_Ep_i$ is the projection of the center of the vertebral body on the line of the vertebral spinous processes in the final position at time t+1,
and **in that** the force linked to the vertebra / back surface orientation corresponds, for each vertebra, to a spring-back equation

$$m_{torsion} = -k_{torsion} * (\theta_{vertèbre} - \theta_{gibbosité}),$$

wherein
$m_{torsion}$ is a spring-back moment along the z axis of the vertebra local coordinate system, $k_{torsion}$ is an angular stiffness,
$\theta_{vertèbre}$ is a vertebral axial rotation angle, and
$\theta_{gibbosité}$ is a gibbosity angle,
the resolution of said equations about the spring-back of the spine with the surface of the back between the two times allowing calculating the stresses applied to the vertebrae of the spine during the deformation and/or displacement thereof between the two times.

7. The method according to any one of the preceding claims, **characterized in that** the equation of the dynamic mechanical model of the spine is:

$$\begin{cases} \phi = 0 \\ [M][\ddot{q}] + [K]^T[\lambda] = [Q] \end{cases}$$

wherein:

$\phi$ is the vector of the rigid-body, kinematic and motor constraints,
M is the matrix of the vertebra masses,
q¨ is the vector of the accelerations of the parameters q,
K is the Jacobian of the constraint vector,
$\lambda$ is the vector of the Lagrange multipliers, and
Q is the vector of the generalized stresses corresponding to the stresses due to the articular stiffnesses and the stiffnesses of interaction between the spine and surface of the back, and the conditions of static equilibrium apply:

$$[K]^T[\lambda] - [Q] = [0]$$
$$Et \ [\phi] = [0].$$

8. The method according to claim 7, **characterized in that** the resolution of the equation of the dynamic mechanical model of the spine is obtained either by a constrained optimization method, wherein the constraints to be respected are the rigid-body constraints, the kinematic constraints and the motor constrains, and the function to be minimized is the potential energy due to the articular stiffnesses and the stiffnesses of interaction between the spine and the surface of the back, or
by a method of iterative resolution of integration of the dynamics equations, the equation of the dynamic mechanical model of the spine being solved by resolution of the system:

$$
\begin{vmatrix} \ddot{q} \\ \lambda \end{vmatrix} = \begin{bmatrix} [M] & [K]^{T} \\ [K] & [0] \end{bmatrix}^{-1} \begin{vmatrix} [Q] \\ -[\dot{K}]\dot{q} \end{vmatrix}
$$

wherein $\ddot{q}$ is the acceleration, $\dot{q}$ is the speed of the parameters q over time, integrations of the accelerations and speeds over time making it possible to determine the speeds $\dot{q}$ and the parameters q until the second time t+1.

9. The method according to any one of the preceding claims, **characterized in that**, further, for said time t+1, the back surface geometry at the time t+1 is calculated, and **in that**, to calculate the position and orientation of each of the vertebra at a time subsequent to t+1, based on 3D images of the external surface of said individual's back, taken at said subsequent time, and while putting back the reference point(s) on the surface of said individual's back, the results of calculation of the position and orientation of each of the vertebrae and the back surface geometry at the previous time, obtained based on 3D images of the external surface of said individual's back, taken at said previous time, are used.

10. A device specially configured for implementing the method according to any one of the preceding claims.

Fig. 1

Fig. 2

Fig. 3

**Fig. 4**

$$t=t_0, n=0, \begin{cases} [q]_0 \\ [\dot{q}]_0 \end{cases} \text{connus}$$

Calcul de $[\phi]_n, [K]_n, [M]_n, [Q]_n, [cb]_n$ en fonction de $t_n, [q]_n$ et $[\dot{q}]_n$

Résolution du système : $\left|\begin{array}{c} \ddot{q} \\ \lambda \end{array}\right|_n = \left[\begin{array}{cc} [M] & [K]^T \\ [K] & [0] \end{array}\right]_n^{-1} \left|\begin{array}{c} [Q] \\ [cb] \end{array}\right|_n$

$\Longrightarrow$ détermination de $|\ddot{q}|_n$

détermination de $|q|_{n+1}$ et $|\dot{q}|_{n+1}$ par intégration numérique, à partir de $|\ddot{q}|_n, |\dot{q}|_n$ et $|q|_n$, avec $t_{n+1}=t_n+\Delta t$

$n=n+1$

non $\longleftarrow$ équilibre ? $\longrightarrow$ oui $\longrightarrow$ fin

**Fig. 5**

Position initiale : détermination
de la projection (NE)

Position en cours de calcul /
surface du dos en position finale

$F_p$

## Fig. 6

X

$Y_{global}$

$M_{torsion}$

$\theta$

## Fig. 7

**Fig. 8**

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008012479 A1

- WO 2008012479 A

**Littérature non-brevet citée dans la description**

- **ZHANG, XIONG.** Model-guided derivation of lumbar vertebral kinematics in vivo reveals the difference between external marker-defined and internal segmental rotations. *Journal of biomechanics,* 2003, vol. 36
- **SUN, LEE ; LU, LUK.** Modelling and simulation of the intervertebral movements of the lumbar spine using an inverse kinematic algorithm. *Med. Biol. Eng. Comput.,* 2004, vol. 42, 740-746
- **F. MARIN ; N. HOANG ; P. AUFAURE ; M.-C. HO BA THO.** In vivo intersegmental motion of the cervical spine using an inverse kinematics procedure. *Clinical Biomechanics,* 2010, vol. 25, 389-396
- **B. DRERUP ; E. HIERHOLTZER.** Back shape measurement using video rasterstereography and three-dimensional reconstruction of spinal shape. *Clinical Biomechanics,* 1994, vol. 9, 28-36
- **HUYSMANS, HAEX ; VAN AUDEKERCKE ; VANDER SLOTEN ; VAN DER PERRE.** Three-dimensional mathematical reconstruction of the spinal shape, based on active contours. *Journal of Biomechanics,* 2004, vol. 37, 1793-1798
- **D'AMICO M ; D'AMICO G ; RONCOLETTA, TOMASSINI ; CIARROCCA, VALLASCIANI.** A 3-D biomechanical skeleton model and processing procedure for posture and movement analysis. *Europa Medicophysica,* 2007, vol. 43, 1-6

- **LAFAGE, DUBOUSSET ; LAVASTE, SKALLI.** 3D finite element simulation of cotrel-dubousset correction. *Computer Aided Surgery,* 2004, vol. 9, 17-25
- **D. PÉRIÉ ; C.-E. AUBIN ; M. LACROIX ; Y: LAFON ; H. LABELLE.** Biomechanical modelling of orthotic treatment of the scoliotic spine including a detailed representation of the brace-torso interface. *Med. Biol. Eng. Comput,* 2004, vol. 42, 339-344
- **AUBIN, PETIT ; STOKES, POULIN ; GARDNER-MORSE, LABELLE.** Biomechanical modeling of posterior instrumentation of the scoliotic spine. *Computer methods in biomechanics and biomedical engineering,* 2003, vol. 21, 77-88, Computer methods in biomechanics and biomedical engineering
- **Y. PETIT ; C-E. AUBIN ; H. LABELLE.** Patient-specific mechanical properties of a flexible multi-body model of the scoliotic spine. *Medical & Biological Engineering & Computing,* 2004, vol. 42, 55-60
- **I. A. STOKES.** Three-dimensional terminology of spinal deformity. A report presented to the Scoliosis Research Society by the Scoliosis Research Society Working Group on 3-D terminology of spinal deformity. *Spine,* 1994, vol. 19, 236-48